# EUROPEAN PATENT APPLICATION

(11) **EP 4 607 220 A1**
(43) Date of publication of application: **27.08.2025**
(21) Application number: 25158437.1
(22) Date of filing: 17.02.2025
(51) Int. Cl.: G01R 31/389, G01R 31/367, G01R 31/382, G01R 31/385, G01R 31/392

(54) **BATTERY ANALYSIS IN AN EVENT DETECTION SYSTEM**

(30) Priority: 21.02.2024 US 202418583182
(71) Applicant: Honeywell International Inc., Charlotte, NC 28202 (US)
(72) Inventor: WOLF, Benjamin H., Charlotte, 28202 (US); BARSON, Michael, Charlotte, 28202 (US); DEARDEN, Christopher, Charlotte, 28202 (US); SM, Srinivas, Charlotte, 28202 (US); KULKARNI, Sagar R., Charlotte, 28202 (US)
(74) Representative: Haseltine Lake Kempner LLP

(57) **Abstract**

Devices, systems, and methods for battery analysis in an event detection system are described herein. In some examples, one or more embodiments include a processor to record a characteristic of a battery in a control panel of the event detection system at predetermined intervals, determine, by the processor via a prediction model using the recorded characteristics, a trend associated with an performance characteristic of the battery, and generate, by the processor, an alert based on the trend associated with the performance characteristic.

## Description

### Technical Field

The present disclosure relates to devices, systems, and methods for battery analysis in an event detection system.

### Background

Facilities, such as commercial facilities, office buildings, hospitals, campuses (e.g., including buildings and outdoor spaces), and the like, may have an event detection system that can be triggered during an event, such as an emergency situation (e.g., a fire) to warn occupants to evacuate. Such an event detection system may include an alarm system having a control panel and a number of event devices (e.g., sensors, sounders, pull stations, etc.) located throughout the facility (e.g., on different floors and/or in different rooms of the facility) that can perform an action when an event (e.g., a hazard event, a fault event, etc.) is occurring in the facility. In an example of an event, the number of event devices may provide a notification of the event to the occupants of the facility via alarms and/or other mechanisms.

### Brief Description of the Drawings

Figure 1 is an example of a system for battery analysis in an event detection system, in accordance with one or more embodiments of the present disclosure.
Figure 2 is an example of a method for battery analysis in an event detection system, in accordance with one or more embodiments of the present disclosure.
Figure 3 is an example of a method for battery analysis in an event detection system, in accordance with one or more embodiments of the present disclosure.
Figure 4 is an example of a controller for battery analysis in an event detection system, in accordance with one or more embodiments of the present disclosure.

### Detailed Description

Devices, systems, and methods for battery analysis in an event detection system are described herein. In some examples, one or more embodiments include a processor to record a characteristic of a battery in a control panel of the event detection system at predetermined intervals, determine, by the processor via a prediction model using the recorded characteristics, a trend associated with an electrical performance characteristic of the battery, and generate, by the processor, an alert based on the trend associated with the performance characteristic.

A facility can utilize an event detection system in order to warn occupants of the facility of an emergency event, such as a fire. An event detection system can be a system of devices that operate to collect information about a facility and provide the collected information for analysis. Such an event detection system can also take actions based on the collected information, such as providing an audible and/or visible warning in an emergency event. For example, the event detection system can utilize event devices to warn occupants of the emergency event occurring in the space, such as a fire. As used herein, the term "event device" refers to a device that can receive an input relating to an event and/or generate an output relating to an event. Such event devices can be a part of the event detection system of a space in a facility/in the facility at large and can include devices such as fire sensors, smoke detectors, heat detectors, carbon monoxide (CO) detectors, or combinations of these; air quality sensors; interfaces; manual call points (MCPs); pull stations; input/output modules; aspirating units; and/or audio/visual devices (e.g., speakers, sounders, flashers, buzzers, microphones, cameras, video displays, video screens, etc.), relay output modules, among other types of event devices. Such event devices may also include self-test capabilities.

The control panel can be connected to the number of event devices and in some examples can provide power to the number of event devices. For example, the number of event devices can be connected to the control panel. The control panel can apply a voltage to the event device loop in order to power the event devices on the event device loop. Such power can allow the event devices to perform actions, such as communication between an event device and the control panel, self-test procedures, and/or provide an audible and/or visible warning in an emergency event, among other actions.

In some instances, the control panel can include a battery which can serve as a backup power source for the number of event devices and the control panel under certain conditions. The battery can be a device which stores electrical energy. For example, if mains power for an event device is lost, the battery included in the control panel can provide power to the event device. In a non-emergency situation, the battery can allow the event device to continue to monitor for emergency events. In an emergency situation, the battery can allow the event device to continue to warn occupants of the space that the emergency event is occurring in the space.

Accordingly, battery functionality can be an important aspect of the event detection system. In some jurisdictions, operational standards can exist that require an event device to operate and perform certain functions on battery power for a certain amount of time. For example, one jurisdiction may require that an event device, such as a smoke detector, can be powered by battery power in a non-emergency scenario for at least twenty-four hours to continue to provide smoke detection capability, and can be powered by battery power in an emergency scenario for at least one hour. Therefore, it can be important to ensure the capacity of the battery is monitored to ensure the battery can perform to certain operational standards.

As a battery is charged and discharged over time, the capacity of the battery can naturally decline. In order to ensure that the battery in the control panel is able to operate and perform to operational standards, testing and monitoring of the battery capacity may occur. For example, a technician can connect a battery capacity meter to terminals of the battery to determine a battery capacity of a battery in a control panel. Such testing may occur once or a few times per year.

However, previous approaches to battery capacity testing and analysis can be time consuming and technical in nature. For example, if a battery capacity meter is not properly calibrated and/or is not correctly bonded to the battery terminals, a false capacity reading can be generated. Such a reading may lead to batteries being replaced prematurely. Further, a technician may have to test multiple batteries in different locations on site, resulting in costly site visits for a building owner.

Additionally, batteries from different manufacturers can have different operating and/or performance characteristics. Further, even batteries from a same manufacturer may have different operating and/or performance characteristics based on temperatures in an environment in which they are deployed.

Unpredictable operating and/or performance characteristics based on different manufacturers and/or different deployment environments can result in variations in capacity readings. This may result in additional and/or unplanned site visits. Further, if a battery fault occurs, building owners may have to give immediate attention to replacing a faulty battery in order to ensure that the event detection system remains functional in the event battery power has to be utilized for the event detection system.

Battery analysis according to the disclosure can allow for ongoing, remote testing and analysis of a battery in a control panel. Such an approach can be faster and less technically demanding than previous approaches, preventing the need for costly testing site visits by technicians. Further, battery analysis according to the disclosure can perform capacity measurements more often than previous approaches and at the same time reduce the chances of false readings, resulting in more reliable capacity measurements and predictions.

Further, prediction of when an performance characteristic of a battery is going to exceed a threshold can allow users, such as building owners and/or maintenance personnel, to predict when a battery should be replaced, and can allow for better and more efficient planning for future site visits by technicians. Moreover, such an approach can allow for replacement of batteries before faults related to diminished battery capacity occur. As a result, battery analysis according to the disclosure can provide a more reliable and safer event detection system as compared with previous approaches.

In the following detailed description, reference is made to the accompanying drawings that form a part hereof. The drawings show by way of illustration how one or more embodiments of the disclosure may be practiced.

These embodiments are described in sufficient detail to enable those of ordinary skill in the art to practice one or more embodiments of this disclosure. It is to be understood that other embodiments may be utilized and that process, electrical, and/or structural changes may be made without departing from the scope of the present disclosure.

As will be appreciated, elements shown in the various embodiments herein can be added, exchanged, combined, and/or eliminated so as to provide a number of additional embodiments of the present disclosure. The proportion and the relative scale of the elements provided in the figures are intended to illustrate the embodiments of the present disclosure and should not be taken in a limiting sense.

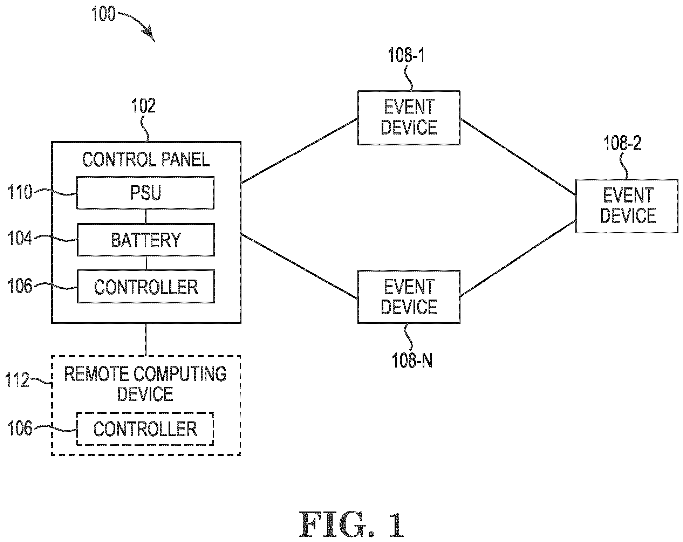

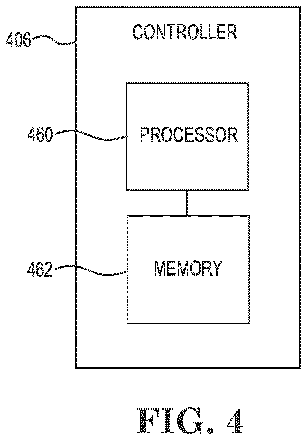

The figures herein follow a numbering convention in which the first digit or digits correspond to the drawing figure number and the remaining digits identify an element or component in the drawing. Similar elements or components between different figures may be identified by the use of similar digits. For example, 106 may reference element "06" in Figure 1, and a similar element may be referenced as 406 in Figure 4.

As used herein, "a", "an", or "a number of" something can refer to one or more such things, while "a plurality of" something can refer to more than one such things. For example, "a number of components" can refer to one or more components, while "a plurality of components" can refer to more than one component.

Figure 1 is an example of a system 100 for battery analysis in an event detection system, in accordance with one or more embodiments of the present disclosure. The system 100 can include a control device panel 102, event devices 108-1, 108-2, 108-N, and in some examples, remote computing device 112.

As mentioned above, the system 100 can be included in a facility, a space in a facility, etc. The system 100 can include a device/series of devices in order to detect events and/or process and/or analyze the detected events to determine whether to generate an alarm for occupants of the facility.

For example, the system 100 can include event devices 108-1, 108-2, 108-N (referred to collectively as event devices 108). The event devices 108 can be devices to detect an event and transmit the detected event for processing and/or analysis. As mentioned above, the event devices 108 can include, for example, cameras, motion sensors, fire sensors, smoke detectors, heat detectors, carbon monoxide (CO) detectors, fixed gas and/or flame detectors, aspirating smoke detectors, beam smoke detectors, or combinations of these; air quality sensors; interfaces; manual call points (MCPs); pull stations; input/output modules; aspirating units; sprinkler controls; and/or audio/visual devices (e.g., speakers, microphones, cameras, video displays, video screens, etc.), relay output modules, among other types of event devices. Additionally, event devices 108 may also include self-test capabilities.

The system 100 can further include a control panel 102. The control panel 102 can be utilized to control the various event devices 108 included in the system 100.

In some examples, the event device panel 102 can be connected to the event devices 108 in an event device loop. The event device loop can be a closed electrical path through different nodes. For example, the event device loop can consist of a closed loop between event device 108-1, 108-2, 108-N, and finally the control panel 102.

Accordingly, and as mentioned above, the control panel 102 can be connected to the event devices 108, transmit a plurality of commands to the event devices 108 via the event device loop, and/or provide power to the event devices 108. For example, the event device panel 102 can apply a voltage to the event device loop in order to power event devices 108 on the event device loop. Such power can allow the event devices 108 to perform actions, such as communication between an event device 108 and the control panel 102, self-test procedures, and/or provide an audible and/or visible warning in an emergency event, among other actions.

As mentioned above, in some circumstances, mains power to the control panel 102/event devices 108 may be lost. Accordingly, the battery 104 included in the control panel 102 can provide power to the event devices 108 in the event mains power is lost. The battery 104 can provide such power in non-emergency situations, as well as during emergency events.

The battery 104 may be charged by the power supply unit 110. The power supply unit 110 can be a device that converts mains power to regulated power for other components. For example, the power supply unit 110 can convert mains alternating current (AC) to a regulated direct current (DC) voltage for charging the battery 104.

As mentioned above, as the battery 104 goes through charge and discharge cycles through its life cycle, the performance characteristic of the battery 104 can diminish. Accordingly, a controller 106 can determine a trend related to the performance characteristic of the battery 104 over time and predict when the performance characteristic of the battery 104 may diminish beyond a predetermined threshold so that the battery may be scheduled for replacement, as is further described herein.

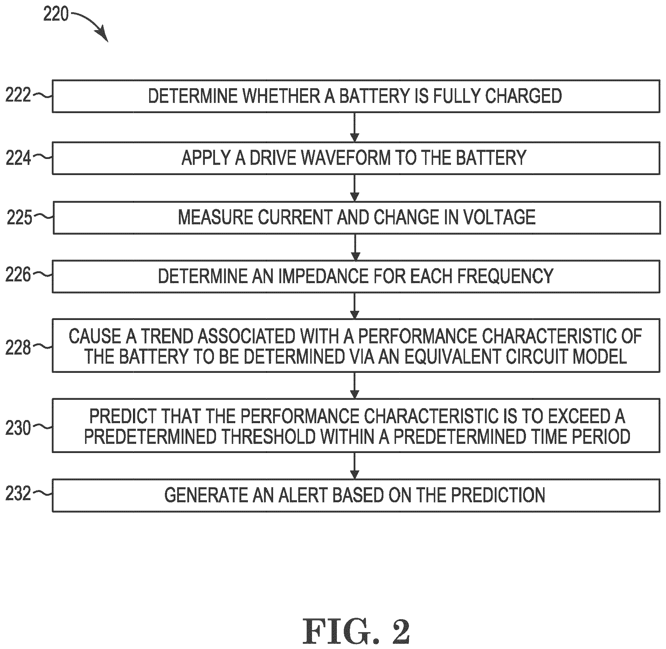

To determine the trend related to the performance characteristic of the battery 104, the controller 106 can record a characteristic of the battery 104 in the control panel 102 at predetermined intervals. In some examples, characteristics of the battery 104 may include a temperature of the battery 104, a current of the battery 104 (e.g., to determine an impedance of the battery 104, as is further described in connection with Figure 2), as well as a timestamp of each recorded reading. For example, the controller 106 can record the temperature of the battery 104 to be 25.1 degrees Celsius (°C), the current of the battery 104 to be 3 amperes (A), and the timestamp to be 04:30:31 AM (e.g., Hours:Minutes:Seconds) on December 7, 2022. Additionally, the predetermined interval may be every 24 hours, so the controller 106 can record another temperature of the battery 104 to be 25.3 °C, the current of the battery 104 to be 3.2 A, and the timestamp to be 04:30:31 AM on December 8, 2022, etc. Additionally, the current of the battery can be recorded across different frequencies of pulsating AC as well as during a load test.

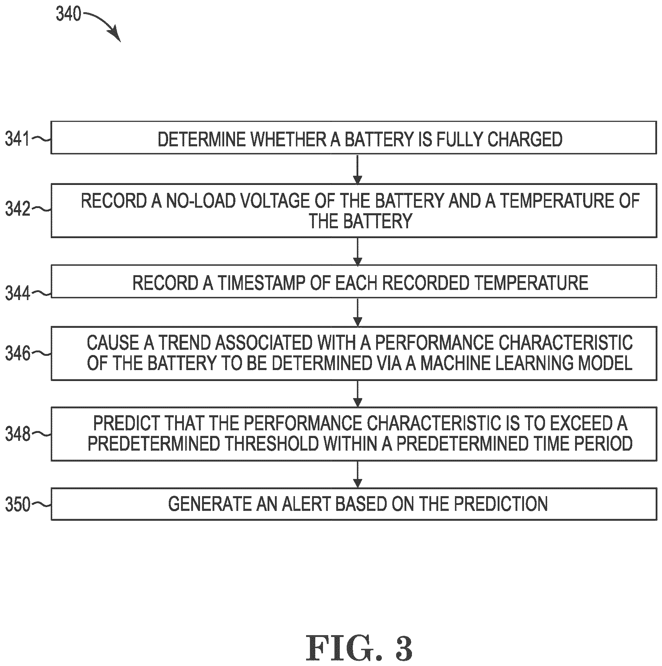

Additionally, although the characteristics are described above as including a temperature of the battery 104, a current of the battery 104, and the timestamp of each recorded reading, embodiments of the present disclosure are not so limited. For instance, in some examples, characteristics of the battery 104 may include a temperature of the battery 104, a no-load voltage of the battery 104 (e.g., as is further described in connection with Figure 3), as well as a timestamp of each recorded reading. For example, the controller 106 can record the temperature of the battery 104 to be 25.1 degrees Celsius (°C), the no-load voltage of the battery 104 to be 12.1 volts (V), and the timestamp to be 04:30:31 AM on December 7, 2022. Additionally, the predetermined interval may be every 24 hours, so the controller 106 can record another temperature of the battery 104 to be 25.3 °C, the no-load voltage of the battery 104 to be 12.0 V, and the timestamp to be 04:30:31 AM on December 8, 2022, etc.

Although the battery 104 is described above as being a 12 V battery included in a 12 V system, embodiments of the present disclosure are not so limited. For example, the battery 104 can be any other battery type, voltage, and/or included in any other voltage-rated system.

Utilizing the recorded characteristics, the controller 106 can determine a trend associated with the performance characteristic of the battery 104. For example, the recorded characteristics over time can be utilized in a prediction model to determine a trend associated with the performance characteristic. As used herein, the term "prediction model" refers to a set of rules that can utilize existing data to predict future behavior. In some examples, the prediction model can be an equivalent circuit model, as is further described in connection with Figure 2. In some examples, the prediction model can be a machine-learning model, as is further described in connection with Figure 3.

In some instances, the controller 106 can utilize the prediction model which can be located locally in the control panel 102. However, in some examples, the controller 106 can utilize the prediction model which can be stored remotely, for instance, at the remote computing device 112. For example, although not illustrated in Figure 1 for clarity and so as not to obscure embodiments of the present disclosure, the control panel 102 can be connected to the remote computing device 112 via a gateway. The gateway can be a device (e.g., a building system gateway) that provides a communication link between the control panel 102 and the remote computing device 112. For example, the gateway may enable transmission of data (e.g., system device data, activation signals, etc.) from the event devices 108 and/or the control panel 102 to the remote computing device 112 via the gateway and vice versa.

Additionally, although not illustrated in Figure 1 for clarity and so as not to obscure embodiments of the present disclosure, the controller 106 located in the remote computing device 112 may perform similar processes described above for other batteries not illustrated in Figure 1. For example, the controller 106 may record data over time for multiple batteries. As such data is collected over time, the prediction model utilized can be updated as data is received.

As mentioned above the trend in the performance characteristic can indicate a decrease in the performance characteristic of the battery 104 over time. For example, the performance characteristic of the battery 104 may be 26 Ah when the battery 104 is new. Over time, the performance characteristic of the battery 104 may diminish to 24 Ah. Additionally, as more time elapses, the performance characteristic of the battery 104 may diminish to 23.5 Ah, etc.

Using the recorded characteristics, the controller 106 can determine, or cause to be determined, the trend in the decreasing performance characteristic of the battery 104 using the prediction model. For example, utilizing the recorded characteristics above, the performance characteristic of the battery 104 may decrease from 26 Ah to 24 Ah to 23.5 Ah, and the prediction model can determine a trend according to the timestamps of each recorded temperature and current or no-load voltage.

Utilizing the trend, the controller 106 can predict when the performance characteristic of the battery 104 is to exceed a predetermined threshold within a predetermined time period. For example, based on the environmental conditions of the facility in which the control panel 102 and battery 104 are located, the trend may indicate the performance characteristic of the battery 104 is decreasing at a particular rate, and that the performance characteristic of the battery 104 is to exceed a predetermined threshold (e.g., 80% of the originally rated performance characteristic) within a predetermined time period (e.g., 3 months). That is, if the originally rated performance characteristic of the battery 104 is 26 Ah, the controller 106 can predict that the performance characteristic will dip below 20.8 Ah within 3 months utilizing the determined trend.

As such, the controller 106 can generate an alert based on the trend associated with the performance characteristic. For example, the alert can be generated in response to the trend indicating the performance characteristic is to exceed the predetermined threshold within the predetermined time period. Such an alert may be displayed on a user interface of the control panel 102, may be transmitted to another computing device, may be transmitted to a mobile device, etc. Accordingly, the alert can notify a user that the battery 104 should be replaced. Such a battery replacement may be performed at the next scheduled regular site visit. Such an approach can allow for preventative maintenance against battery faults, as described below. Additionally, in some examples the user may utilize the alert to schedule a service for the battery 104, such as replacement of the battery 104, if such regular site visits are not already scheduled.

Additionally, while the system 100 includes a single control panel 102 and battery 104, embodiments of the present disclosure are not so limited. For example, the system 100 may include multiple control panels having associated controllers/ batteries. The approaches described above, and further below in connection with Figures 2 and 3, may be performed by each controller or by a remote controller for each battery included in the system 100.

Accordingly, battery analysis according to the disclosure can allow for capacity measurement and prediction of capacity of batteries without the use of costly site visits by technicians. Such measurements may be performed more often than in previous approaches, allowing for more robust collection of battery capacity data. Utilizing such data can allow for prediction of future battery capacity, providing users the ability to predict when a battery should be replaced before a battery fault occurs. As a result, battery analysis according to the disclosure can provide a more reliable and safer event detection system, as well as safer and less costly facility operation, as compared with previous approaches.

Figure 2 is an example of a method 220 for battery analysis in an event detection system, in accordance with one or more embodiments of the present disclosure. The method 220 may be performed by a controller (e.g., controller 106, previously described in connection with Figure 1).

The controller can determine a temperature of the battery. At 222, the method 220 can include determining whether the battery is fully charged. For example, the controller can determine the open circuit voltage for the battery and, based on the open circuit voltage at the particular temperature, determine the charge of the battery. Utilizing the charge of the battery, the controller can determine whether the battery is fully charged.

At 224, the controller can generate a drive waveform at a number of frequencies and apply it to the battery. The resulting voltage measured on the battery or current in the battery can enable the impedance of the battery to be calculated at each frequency. For example, the battery can be connected to a power supply unit (e.g., a battery charger) that can be included in the control panel. The controller can enable the battery charger to generate a drive waveform, which can be applied to the battery. The battery can be inside the control panel, or in an external battery box located near the control panel.

In some examples, the drive waveform is pulsed AC. The power supply unit can generate pulsed AC over a range of frequencies and inject the AC current into the battery to cause the battery to generate the current.

In some examples, the variable electric current is an intermittent pulsating DC. The intermittent pulsating DC can be a periodic current which changes in value.

At 225, the controller can measure the current drawn and measure the change in voltage of the battery. The controller can record the current of the battery. The controller can record the current and the temperature at predetermined intervals (e.g., every 15 minutes). Additionally, the controller can record a timestamp of each recorded current and temperature. For example, the controller can record the temperature of the battery to be 25.1 °C, the current of the battery to be 3 A, and the timestamp to be 04:30:31 AM on December 7, 2022, another temperature of the battery 104 to be 25.3 °C, the current of the battery 104 to be 3.2 A, and the timestamp to be 04:45:31 AM on December 7, 2022, etc.

Utilizing the current of the battery, the controller, at 226, can determine an impedance for each recorded current. For example, the controller can determine the impedance of the battery at 04:30:31 AM, again at 04:45:31 AM, etc. The impedance of the battery can be determined for each frequency using the change in voltage of the battery and the measured current.

With each impedance value, the controller can cause a trend associated with the performance characteristic of the battery to be determined at 228. For example, the recorded characteristics over time can be utilized in a prediction model to determine a trend associated with the performance characteristic. In this example, the prediction model can be an equivalent circuit model. In some examples, such a model can be a Randle's model. The equivalent circuit model can be a model of an electrical circuit that describes processes of an electrochemical interface. Utilizing each impedance, temperature, and time stamp, the equivalent circuit model can determine a trend in the performance characteristic of the battery. For example, the performance characteristic of the battery 104 may be 26 Ah when the battery 104 is new. Over time, the performance characteristic of the battery 104 may diminish to 24 Ah, and as time elapses, the performance characteristic of the battery 104 may diminish to 23.5 Ah, etc. This may be predicted by the trend using the measured characteristics of the battery.

At 230, the controller can predict, based on the trend, that the performance characteristic is to exceed a predetermined threshold within a predetermined time period. For example, based on the environmental conditions of the facility in which the control panel and battery are located, the trend may indicate the performance characteristic of the battery is decreasing at a particular rate, and that the performance characteristic of the battery is to exceed 80% of the originally rated performance characteristic within 3 months. Accordingly, if the originally rated performance characteristic of the battery is 26 Ah, and over time the performance characteristic has diminished to 24 Ah and then to 23.5 Ah, as a function of the environmental conditions of the facility, the controller can predict that the performance characteristic will dip below 20.8 Ah within 3 months utilizing the determined trend from the equivalent circuit model.

At 232, the controller can generate an alert based on the prediction. The alert can notify a user to schedule a service for the battery, such as replacement of the battery.

Although the controller is described above as causing the trend to be determined and predicting the performance characteristic is to exceed the predetermined threshold, embodiments of the present disclosure are not so limited. For example, the controller can cause the data collected (e.g., the charge, measured current, and measured change in voltage) to be transmitted to a remote computing device (e.g., a cloud computing environment) where the remote computing device can cause the trend line to be determined and predict the performance characteristic is to exceed the predetermined threshold.

In some examples, the trend can be displayed via a user interface. The trend may include a trend line plotted on a graph of capacity vs. time. The user interface can allow a user to view the trend alongside dated information to allow the user to make various decisions about scheduling technician visits to the facility for battery replacement, etc. Additionally, multiple trends for multiple batteries may be determined, allowing a user to schedule a service for the batteries at the same time, which can save financial resources as compared with having to schedule multiple technicians at different times.

Although an alert is described above as being generated when a prediction for when the performance characteristic is to exceed a predetermined threshold within a predetermined time period, embodiments of the present disclosure are not so limited. For instance, in some examples, an alert may be generated when the performance characteristic is predicted to fall within a specified capacity range. For example, an alert may be generated when the performance characteristic is predicted to fall within a range of 80%-90% of the originally rated capacity. Additionally, in some examples, an alert may be generated when the performance characteristic is predicted to exceed a predetermined threshold within a specified time period range, or is predicted to fall within a specified capacity range within a specified time period range. For example, an alert may be generated when the performance characteristic is predicted to fall within a range of 80%-90% of the originally rated capacity and that is predicted to occur within 3 to 5 months.

Figure 3 is an example of a method 340 for battery analysis in an event detection system, in accordance with one or more embodiments of the present disclosure. The method 340 may be performed by a controller (e.g., controller 106, previously described in connection with Figure 1).

At 341, the controller can determine whether the battery is fully charged. For example, the controller can determine the open circuit voltage for the battery to determine whether the battery is fully charged (e.g., prior to recording characteristics of the battery).

In response to the battery not being fully charged, the controller can cause the battery to be charged by a power supply unit included in the control panel. For example, the controller can cause the power supply unit to charge the battery for a predetermined amount of time, such as for 4 to 8 hours, until the battery is fully charged. Accordingly, when the battery is fully charged, the controller can record the battery characteristics, as is further described herein.

At 342, the controller can record a no-load voltage of the battery and a temperature of the battery. The controller can record the no-load voltage and the temperature at predetermined intervals (e.g., every 15 minutes). Additionally, at 344, the controller can record a timestamp of each recorded no-load voltage and temperature. For example, the controller can record the temperature of the battery to be 25.1 °C, the no-load voltage of the battery to be 12.1 V, and the timestamp to be 04:30:31 AM on December 7, 2022, another temperature of the battery 104 to be 25.3 °C, the no-load voltage of the battery 104 to be 12.0 V, and the timestamp to be 04:45:31 AM on December 7, 2022, etc.

With each no-load voltage value, the controller can cause a trend associated with the performance characteristic of the battery to be determined at 346. For example, the recorded characteristics over time can be utilized in a prediction model to determine a trend associated with the performance characteristic. The fully charged voltage of the battery vs. battery capacity can be a known relationship. In this example, the prediction model can be a machine-learning model. The machine-learning model can be a linear regression model, logistic regression model, decision tree model, gradient boosted model, neural networks, and/or any other predictive machine-learning model. Utilizing each no-load voltage, temperature, and time stamp, the machine-learning model can determine a trend in the performance characteristic of the battery. For example, the performance characteristic of the battery 104 may be 26 Ah when the battery 104 is new. Over time, the performance characteristic of the battery 104 may diminish to 24 Ah, and as time elapses, the performance characteristic of the battery 104 may diminish to 23.5 Ah, etc. This may be predicted by the trend using the measured characteristics of the battery.

At 348, the controller can predict, based on the trend, that the performance characteristic is to exceed a predetermined threshold within a predetermined time period. For example, based on the environmental conditions of the facility in which the control panel and battery are located, the trend may indicate the performance characteristic of the battery is decreasing at a particular rate, and that the performance characteristic of the battery is to exceed 80% of the originally rated performance characteristic within 3 months. Accordingly, if the originally rated performance characteristic of the battery is 26 Ah, and over time the performance characteristic has diminished to 24 Ah and then to 23.5 Ah, as a function of the environmental conditions of the facility, the controller can predict that the performance characteristic will dip below 20.8 Ah within 3 months utilizing the determined trend from the machine-learning model.

At 350, the controller can generate an alert based on the prediction. The alert can notify a user to schedule a service for the battery, such as replacement of the battery, among other things, as previously described above.

Although the controller is described above as causing the trend to be determined and predicting the performance characteristic is to exceed the predetermined threshold, embodiments of the present disclosure are not so limited. For example, the controller can cause the data collected (e.g., the no-load voltage, temperature, etc.) to be transmitted to a remote computing device (e.g., a cloud computing environment) where the remote computing device can cause the trend line to be determined and predict the performance characteristic is to exceed the predetermined threshold.

Figure 4 is an example of a controller 406 for battery analysis in an event detection system, in accordance with one or more embodiments of the present disclosure. As illustrated in Figure 4, the controller 406 can include a memory 462 and a processor 460 for battery analysis in an event detection system, in accordance with the present disclosure.

The memory 462 can be any type of storage medium that can be accessed by the processor 460 to perform various examples of the present disclosure. For example, the memory 462 can be a non-transitory computer readable medium having computer readable instructions (e.g., executable instructions/computer program instructions) stored thereon that are executable by the processor 330 for command transmission based on an electrical measurement in an event detection system in accordance with the present disclosure.

The memory 462 can be volatile or nonvolatile memory. The memory 462 can also be removable (e.g., portable) memory, or non-removable (e.g., internal) memory. For example, the memory 462 can be random access memory (RAM) (e.g., dynamic random access memory (DRAM) and/or phase change random access memory (PCRAM)), read-only memory (ROM) (e.g., electrically erasable programmable read-only memory (EEPROM) and/or compact-disc read-only memory (CD-ROM)), flash memory, a laser disc, a digital versatile disc (DVD) or other optical storage, and/or a magnetic medium such as magnetic cassettes, tapes, or disks, among other types of memory.

Further, although memory 462 is illustrated as being located within controller 406, embodiments of the present disclosure are not so limited. For example, memory 462 can also be located internal to another computing resource (e.g., enabling computer readable instructions to be downloaded over the Internet or another wired or wireless connection).

The processor 460 may be a central processing unit (CPU), a semiconductor-based microprocessor, and/or other hardware devices suitable for retrieval and execution of machine-readable instructions stored in the memory 462.

Although specific embodiments have been illustrated and described herein, those of ordinary skill in the art will appreciate that any arrangement calculated to achieve the same techniques can be substituted for the specific embodiments shown. This disclosure is intended to cover any and all adaptations or variations of various embodiments of the disclosure.

It is to be understood that the above description has been made in an illustrative fashion, and not a restrictive one. Combination of the above embodiments, and other embodiments not specifically described herein will be apparent to those of skill in the art upon reviewing the above description.

The scope of the various embodiments of the disclosure includes any other applications in which the above structures and methods are used. Therefore, the scope of various embodiments of the disclosure should be determined with reference to the appended claims, along with the full range of equivalents to which such claims are entitled.

In the foregoing Detailed Description, various features are grouped together in example embodiments illustrated in the figures for the purpose of streamlining the disclosure. This method of disclosure is not to be interpreted as reflecting an intention that the embodiments of the disclosure require more features than are expressly recited in each claim.

Rather, as the following claims reflect, inventive subject matter lies in less than all features of a single disclosed embodiment. Thus, the following claims are hereby incorporated into the Detailed Description, with each claim standing on its own as a separate embodiment.

## Claims

1. A method (220, 340) for battery analysis in an event detection system (100), comprising:
recording, by a processor (460), a characteristic of a battery (104) in a control panel (102) of the event detection system (100) at predetermined intervals;
determining, by the processor (460) via a prediction model using the recorded characteristics, a trend associated with a performance characteristic of the battery (104); and
generating, by the processor (460), an alert based on the trend associated with the performance characteristic.

2. The method (220, 340) of claim 1, wherein the method (220, 340) includes predicting, by the processor (460) based on the trend, that the performance characteristic is to exceed a predetermined threshold within a predetermined time period.

3. The method (220, 340) of claim 2, wherein the method (220, 340) includes generating, by the processor (460), the alert in response to the trend indicating the performance characteristic is to exceed the predetermined threshold within the predetermined time period.

4. The method (220, 340) of claim 1, wherein the trend in the performance characteristic indicates a decrease in the performance characteristic of the battery (104) over time.

5. The method (220, 340) of claim 1, wherein the prediction model is a machine-learning model that updates as further data is collected.

6. The method (220, 340) of claim 1, wherein the prediction model is an equivalent circuit model.

7. The method (220, 340) of claim 1, wherein recording the characteristic includes recording, by the processor (460), a current of the battery (104), a temperature of the battery (104), and a timestamp of each recorded current and temperature at each predetermined interval across different frequencies.

8. The method (220, 340) of claim 1, wherein recording the characteristic includes recording, by the processor (460), a no-load voltage of the battery (104) when the battery (104) is fully charged, a temperature of the battery (104), and a timestamp of each recorded no-load voltage and temperature at each predetermined interval.

9. A controller (106, 406) for battery (104) analysis in an event detection system (100), comprising:
a memory (462); and
a processor (460) configured to execute executable instructions stored in the memory (462) to:
record:
a current of a battery (104) and a temperature of the battery (104) at predetermined intervals across different frequencies; and
a timestamp of each recorded current and temperature, wherein the battery (104) is included in a control panel (102) of the event detection system (100);
determine an impedance for each frequency;
cause a trend associated with a performance characteristic of the battery (104) to be determined via an equivalent circuit model using each impedance, each temperature, and each time stamp at each predetermined interval;
predict, based on the trend, that the performance characteristic is to exceed a predetermined threshold within a predetermined time period; and
generate an alert based on the prediction.

10. The controller (106, 406) of claim 9, wherein the processor (460) is configured to execute the instructions to cause a variable electric current to be generated and transmitted to the battery (104) to cause the battery (104) to generate the current.

11. The controller (106, 406) of claim 10, wherein the variable electric current is a pulsed alternating current (AC) at different current levels.

12. The controller (106, 406) of claim 10, wherein the variable electrical current is an intermittent pulsating direct current (DC).

13. The controller (106, 406) of claim 9, wherein the controller (106, 406) is:
to record a current and a temperature of the battery (104) over time; and
to record a current and a temperature of other batteries over time.

14. The controller (106, 406) of claim 13, wherein the controller (106, 4060) is located remotely from the battery (104) and the other batteries.

15. The controller (106, 406) of claim 9, wherein the processor (460) is configured to execute the instructions to cause the trend to be displayed via a user interface.
